**Europäisches Patentamt**

**European Patent Office**

**Office européen des brevets**

(19)

(11) Publication number: **0 111 651**
**B1**

(12) **EUROPEAN PATENT SPECIFICATION**

(45) Date of publication of patent specification: **09.08.89**

(51) Int. Cl.⁴: **H 01 L 21/76**

(21) Application number: **83109585.6**

(22) Date of filing: **26.09.83**

(54) **Semiconductor device comprising dielectric isolation regions.**

(30) Priority: **29.09.82 JP 168355/82**

(43) Date of publication of application:
**27.06.84 Bulletin 84/26**

(45) Publication of the grant of the patent:
**09.08.89 Bulletin 89/32**

(84) Designated Contracting States:
**DE FR GB IT**

(56) References cited:
**EP-A-0 020 994**
**EP-A-0 048 175**
**DE-A-2 949 360**
**US-A-4 233 091**

**IBM TECHNICAL DISCLOSURE BULLETIN, vol.
25, no. 5, October 1982, pages 2292-2293, New
York, US; S.D. MALAVIYA: "Self-aligned deep
trench isolation for bipolar transistors"**

(73) Proprietor: **HITACHI, LTD.**
**6, Kanda Surugadai 4-chome Chiyoda-ku
Tokyo (JP)**

(72) Inventor: **Tamaki, Yoichi**
**217, Higashikoigakubo-1-chome
Kokubunji-shi (JP)**
Inventor: **Shiba, Takeo**
**1473, Josuihoncho
Kodaira-shi (JP)**
Inventor: **Sagara, Kazuhiko**
**12-19, Amanuma-2-chome
Suginami-ku Tokyo (JP)**
Inventor: **Kawamura, Masao**
**5-14, Shinmachi-1-chome
Fuchu-shi (JP)**

(74) Representative: **Strehl, Peter, Dipl.-Ing. et al
Patentanwälte Strehl Schübel-Hopf Groening
Schulz Maximilianstrasse 54 Postfach 22 14 55
D-8000 München 22 (DE)**

## Description

The present invention relates to a semiconductor device, and more particularly to a semiconductor device in which a plurality of semiconductor devices are electrically isolated from each other by grooves formed in a semiconductor substrate.

A device in accordance with the first part of the appended claim 1 is known from EP—A1—0020994.

An isolation method of isolating semiconductor devices by forming grooves in a semiconductor substrate and filling the grooves with insulative material requires a smaller space and attains a smaller parasitic capacitance than a PN junction isolation method and it is suitable to a high integration and high speed LSI. However, in this method, if the grooves on the surface after the insulating material has been filled in the grooves are wide, it is difficult to flatten the surface and a very complex process is required to flatten the surface. Accordingly, the width of the grooves is restricted to facilitate the flattening. However, when the width of the isolation grooves is restricted, parasitic active regions are created in the devices on the opposite sides of the groove and a wiring capacitance increases, which results in a reduction of an operation speed of the circuit.

It is an object of the present invention to provide a semiconductor device which can reduce a stray capacity of wiring on a passive region without complexing a manufacturing process.

The isolation in accordance with the present invention uses a combination of a pair of narrow and deep grooves, thick oxide films on the surfaces of the grooves and a thick oxide film on a surface area between the grooves.

Figs. 1 to 8 show manufacturing steps of one embodiment of the present invention,

Figs. 9 to 12 show manufacturing steps of a second embodiment of the present invention,

Figs. 13 and 14 show manufacturing steps of a third embodiment of the present invention, and

Figs. 15 to 17 show manufacturing steps of other embodiments of the present invention.

The fact that a propagation delay time of 0.3 ns/gate with an isolation capacitance of 0.2 pF is attained by forming grooves in a semiconductor integrated circuit substrate is disclosed in an article Japanese Journal of Applied Physics, Volume 21 (1982) Supplement 21-1, pages 37—40, two of the authors of which are the inventors of the present invention.

U.S. Patent 4,396,460, published on August 2, 1983, invented by the authors of the above article and filed on May 21, 1982 discloses a method for flattening an area of a wide isolation groove.

A first embodiment concerning the manufacturing of a bipolar integrated circuit is now explained.

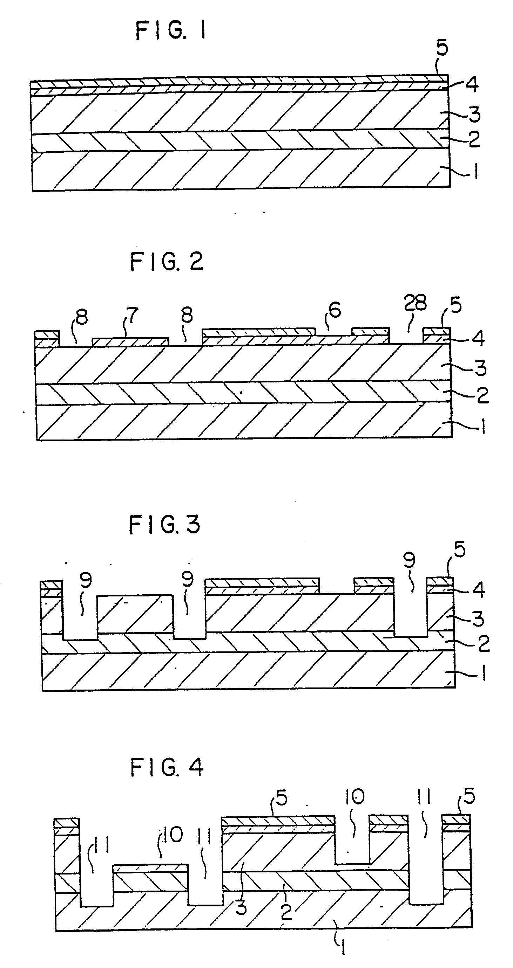

As shown in Fig. 1, a collector buried layer 2 of a thickness of 0.5—3 µm is formed in a surface of a Si substrate 1 having a plane orientation (100), a Si epitaxial layer (having a thickness of 0.5—3 µm,

preferably 1—1.5 µm) which serves as an active region of a transistor is formed thereon, the surface thereof is oxidized to form a $SiO_2$ film 4 having a thickness of 0.05—0.10 µm, and a $Si_3N_4$ film 5 is formed thereon by a well-known CVD process.

Then, the $Si_3N_4$ film 5 at areas 6, 7, 8 and 28 in which grooves are to be formed as shown in Fig. 2 are selectively removed by a dry-etching process using a conventional photo-etching method, and the surface is again photo-etched to remove the exposed areas 8 and 28 of the $SiO_2$ film 4 while leaving the $SiO_2$ film 4 at an area of a shallow isolation groove 6 and at a center area 7 of a wide isolation area 8-7-8 having a width of 0.5 to 2000 µm to form openings 8 and 28 at areas in which deep device isolation grooves are to be formed. The widths of the openings 6, 8 and 28 are preferably equal to or narrower than the depths of the grooves to be described later, from a standpoint of later flattening process.

Then, as shown in Fig. 3, generally vertical grooves 9 are formed in the Si layer 3 by a well-known dry etching process such as a reactive sputter etching using the $SiO_2$ film 4 of the areas 6 and 7 as a mask. Before dry etching, The $SiO_2$ film 4 may be etched to widen the openings 6, 8 and 28 to diverge the tops of the grooves upward to enhance the flatness of the surface. This shape is hereinafter referred to as a Y-shaped groove. The flatness of this Y shaped groove is advantageous to a multi-layered integrated circuit structure having an element or wiring stacked on the other element. The groove 9 extends through the Si epitaxial layer 3 and into the collector buried layer 2 by approximately 0.5 µm.

The exposed areas of the $SiO_2$ films 4 and 6 between the grooves 9 are removed by wet etching process using buffered HF as on etchant (Fig. 3).

Then, the Si films 3, 2 and 1 are again dry-etched to form interdevice isolation grooves 10 which are shallower than the collector buried layer 2 and deep device-to-device isolation grooves 11 which extend into the collector buried layer 2 (Fig. 4). The depth of the grooves 11 is 1.5 µm—6.5 µm depending on the thicknesses of the collector buried layer 2 and the Si epitaxial layer 3.

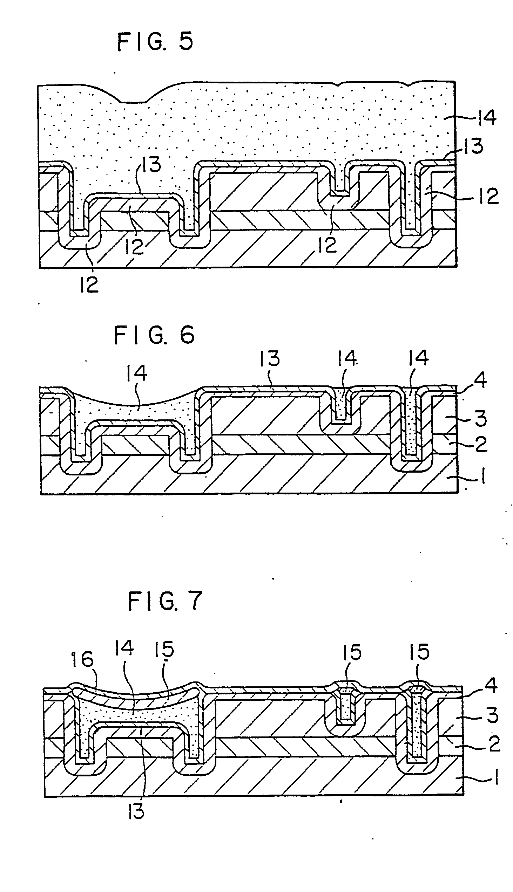

The exposed areas of the Si films 1, 2 and 3 are then oxidized using the $Si_3N_4$ film 5 as a mask to form a $SiO_2$ film 12 having a thickness of approximately 400 nm. After the $Si_3N_4$ film 5 used as the mask has been removed, a $Si_3N_4$ film 13 having a thickness of approximately 100 nm is formed on an entire surface, and a thick poly-Si layer 14 is formed by CVD process to fill the grooves (Fig. 5).

The poly-Si 14 is then etched by isotropic etching (either dry or wet) until the surface of the $Si_3N_4$ film 13 is exposed to flatten the surface (Fig. 6).

Then, the surface of the poly-Si 14 is oxidized to form a $SiO_2$ film 15 having a thickness of approximately 400 nm and the exposed areas of the $Si_3N_4$ film 13 are removed and a $Si_3N_4$ film 16 having a thickness of approximately 100 nm is formed on the entire surface. Thus, the interdevice and device-to-device isolation processes are completed (Fig. 7).

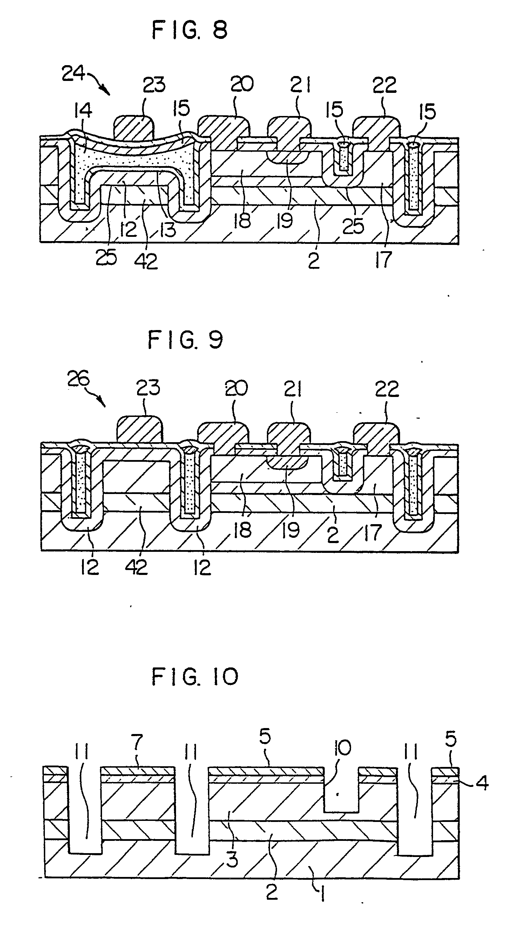

Then, a collector take-out region 17, a base region 18 and an emitter region 19 are formed by diffusion or ion implantation, and passivation film 16 formed in the step of Fig. 7 and the $SiO_2$ film 4 are selectively etched using a mask to form a base electrode 20, an emitter electrode 21 and a collector electrode 22 to complete a transistor (Fig. 8). A conductive line 23 deposited above the filling poly-Si layer is also shown in Fig. 8.

The bipolar LSI thus constructed has two thick oxide layers 12 and 15 and two $Si_3N_4$ layers 13 and 16 in the interdevice isolation area 24. Let us consider a parasitic capacitance between the conductive line 23 and the substrate 1. The dielectric constant of the $Si_3N_4$ films 13 and 16 is approximately 2 to 4 µm. The thicknesses of the films are about 100 nm. The poly-Si layer 14 is sandwiched between the films. This dielectric constant is larger than that of the $SiO_2$ film whose relative dielectric constant is approximately 2.8. Accordingly, the contribution of the $Si_3N_4$ film of 100 nm thickness to the capacitance corresponds to that of the $SiO_2$ film of about 70 nm thickness. Accordingly, if the poly-Si film 14 is disregarded, two pairs of $Si_3N_4$—$SiO_2$ films have a capacitance corresponding to the $SiO_2$ film having a thickness of 940 nm, that is, approximately $1 \times 10^{-5}$ pF/µm². A single pair of the 100 nm thick $Si_3N_4$ film and the 50 nm thick $SiO_2$ film has a capacitance corresponding to the $SiO_2$ film having a thickness of 120 nm, that is, approximately $9 \times 10^{-5}$ pF/µm². Accordingly, the parasitic capacitance of the present embodiment is one nineth of that of the prior art device. An electric resistance of the poly-Si layer 14 of Fig. 8 is in the order of 10 MΩ-cm but it may be considered that a depletion layer is formed in the poly-Si layer 14 by an electric field applied thereto to reduce the parasitic capacitance by a certain degree.

In the embodiment of Fig. 8, the bottoms 25 of the two shallow grooves reach the surface of the collector buried layer 2. The thickness of the poly-Si layer 14 depends on the thicknesses of the collector buried layer 2 and the Si epitaxial layer 3.

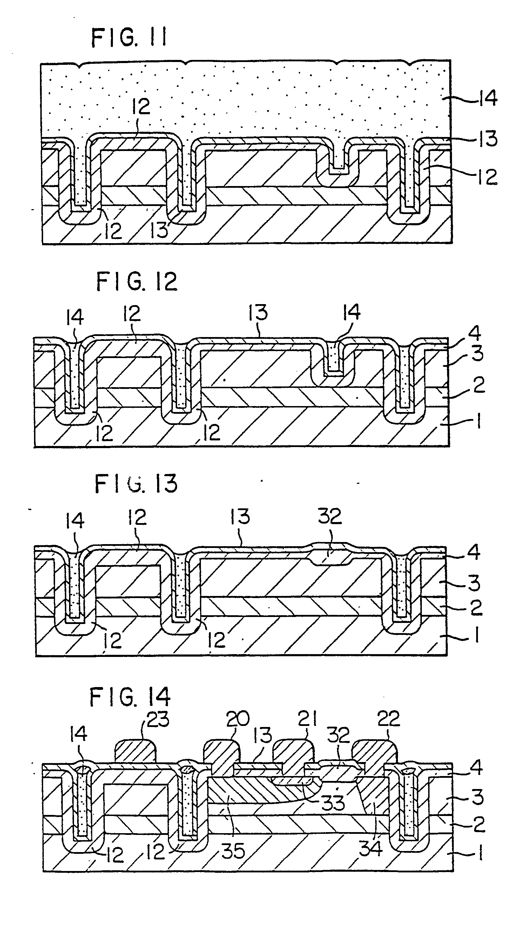

When it is not required that the shallow grooves extend to the collector buried layer, the amount of etching of the Si layer 14 for the shallow grooves in the step of Fig. 4 may be reduced. The etching step of Fig. 4 for forming the shallow grooves may be omitted. The thickness of the poly-Si layer 14 is 0—5.5 µm. By selecting the depth of the shallow grooves 10 to approximately one half of the thickness of the $SiO_2$ film 12, the flatness of the surface 26 relative to the other areas is attained by thermal oxidation as shown in Fig. 9. Figs. 10—12 shows manufacturing steps for a second embodiment shown in Fig. 9. They correspond to Figs. 4—6, respectively. The Si epitaxial layer 3 in the wide isolation region 7 shown in Fig. 10 is not etched. Figs. 11 and 12 show the same steps as those shown in Figs. 5 and 6, respectively. The thickness of the $SiO_2$ film 12 shown in Fig. 11 may be slightly larger than the thickness of 400 nm of the $SiO_2$ film shown in Fig. 5, that is, it may be 500—600 nm. As a result, a stray capacitance which is approximately 1/4.5 to 1/5 of that of the 120 nm thick $SiO_2$ film is attained. The collector buried layer 42 shown in Figs. 8 and 9 is isolated by the deep groove from the other collector buried layer 2.

The device isolations in the first and second embodiments were applied to devices of a bipolar semiconductor integrated circuit and to the peripheries of bonding pads (approximately 100 µm×100 µm) and the underlying areas of the wirings from the bonding pads to the circuit components. A propagation delay time was 0.2 ns/gate. It shows an improvement of 50% over the propagation delay time of 0.3 ns/gate shown in the article of the JJAP.

Figs. 13 and 14 show a third embodiment. The shallow groove 10 shown in Fig. 10 is formed for the interdevice isolation. In Fig. 13, the step of forming the shallow groove 10 is omitted and the interdevice isolation is attained by a $SiO_2$ film 32 having a thickness of 400—600 nm formed by thermal oxidization. Fig. 14 shows a collector diffusion region 34, an emitter diffusion region 33 and a base diffusion region 35 having their diffusion regions delimited by the $SiO_2$ film 32.

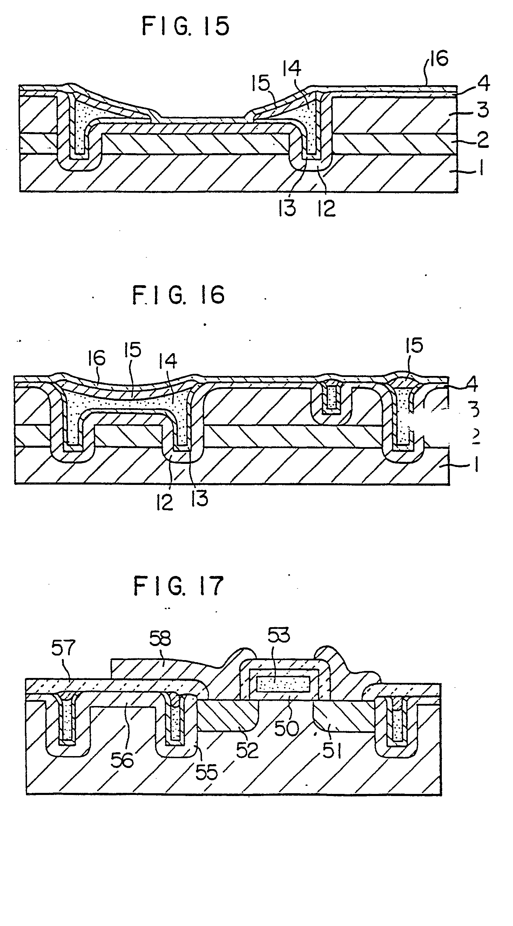

Fig. 15 shows a fourth embodiment in which the width of the interdevice isolation region of the above embodiment is widened to 10 µm or longer. The surface has no step and has a smooth contour.

Fig. 16 shows a fifth embodiment.

The cross-sectional shape of the groove is not limited to the U-shape shown in the embodiment but a V-shape or a Y-shape or combination of the three shapes may be used. By over-etching the $SiO_2$ film 4 shown in Fig. 2 and isotropic-etching it by alkaline etchant (KOH or hydradin) in an early stage of Si etching to form a Y-shaped slope at the top of the deep cylindrical groove to widen the top outward, the flatness of the surface is improved as shown in Fig. 16.

In the above embodiments, the filling material 14 for the isolation grooves is the poly-Si. Alternatively, other insulating material such as $SiO_2$ or $Si_3N_4$ may be used. The thickness of the $Si_3N_4$ film for masking or passivation is not limited to 100 nm but it may change between 30 nm and 500 nm.

Fig. 17 shows an embodiment of a MOS LSI in accordance with the present invention. A source 51, a drain 52, a poly-Si gate 53 and a thin gate oxidization film 50 under the gate 53 are similar to those of a conventional MOS FET structure. An Al conductive wire 58 is contacted to the drain 52 and extends onto a $SiO_2$ film 56 having a thickness of 200 nm to 1 µm between two grooves 55 having a depth of approximately 0.3 to 1.0 µm, and onto a passivation layer 57 (such as PSG).

## Claims

1. A semiconductor integrated circuit device including

a silicon substrate (1),

device areas (2, 3) disposed on the substrate (1) and covered by a first silicon oxide layer (4),

circuit elements (17 . . . 22; 50 . . . 53) formed in said device areas (2, 3),

isolation areas (24) separating said device areas (2, 3) from each other, each isolation area (24) including a pair of mutually spaced grooves (9) extending to said substrate (1) and a second silicon oxide layer (12) formed on the inner surfaces of said grooves (9) and between the paired grooves (9), the second silicon oxide layer (12) being thicker than said first silicon oxide layer (4), and

wirings (23) disposed on said isolation areas (24) for interconnecting said circuit elements (17 . . . 19), characterized in

that a silicon nitride layer (13) is provided in addition to said second silicon oxide layer (12) at least in the paired grooves and

that the second silicon oxide layer (12) is made by thermal oxidation and has substantially the same thickness in said grooves (9) and between the paired grooves (9).

2. The device of claim 1, comprising a polycrystalline silicon layer (14) formed on said second silicon oxide layer (12) and silicon nitride layer (13).

3. The device of claim 2, wherein said grooves (9) are filled with a stacked structure comprising said second silicon oxide layer (12), silicon nitride layer (13) and polycrystalline silicon layer (14), all these layers extending into said grooves (9) and intruding into said silicon substrate (1).

4. The device of any of claims 1 to 3, wherein said circuit elements include MOSFETs (50 . . . 53).

5. The device of any of claims 1 to 3, wherein said circuit elements include bipolar devices (17 . . . 22) and said pair of grooves (9) extend through a collector buried layer (2) formed in said silicon substrate (1).

6. The device of any of claims 2 to 6, comprising

a third silicon oxide layer (15) formed on said polycrystalline silicon layer (14) of said insulation area (24), and

a second silicon nitride layer (16) formed on said third silicon oxide layer (15) and contacting said first silicon nitride layer (13) to enclose said polycrystalline silicon layer (14).

## Patentansprüche

1. Integrierte Halbleiterschaltungs-Vorrichtung mit

einem Siliziumsubstrat (1),

auf dem Substrat (1) angeordneten und mit einer ersten Siliziumoxidschicht (4) bedeckten Vorrichtungsbereichen (2, 3),

in den Vorrichtungsbereichen (2, 3) ausgebildeten Schaltungselementen (17 . . . 23; 50 . . . 53),

die Vorrichtungsbereiche (2, 3) voneinander trennenden Isolierbereichen (24), deren jeder ein Paar von in gegenseitigem Abstand voneinander angeordneten und bis zu dem Substrat (1) verlaufenden Nuten (9) und eine an den Innenflächen der Nuten (9) und zwischen den paarweise zusammengehörenden Nuten (9) ausgebildete zweite Siliziumoxidschicht (12) aufweist, wobei die zweite Siliziumoxidschicht (12) dicker ist als die erste Siliziumoxidschicht (4), und

auf den Isolierbereichen (24) angeordneten Verdrahtungen (23) zum Verbinden der Schaltungselemente (17 . . . 19), dadurch gekennzeichnet,

daß zusätzlich zu der zweiten Siliziumoxidschicht (12) in den paarweise zusammengehörigen Nuten eine Siliziumnitridschicht (13) vorgesehen ist, und

daß die zweite Siliziumoxidschicht (12) durch thermische Oxidation hergestellt ist sowie in den Nuten (9) und zwischen den paarweise zusammengehörigen Nuten (9) im wesentlichen die gleiche Dicke hat.

2. Vorrichtung nach Anspruch 1, umfassend eine auf der zweiten Siliziumoxidschicht (12) und der Siliziumnitridschicht (13) ausgebildete polykristalline Siliziumschicht (14).

3. Vorrichtung nach Anspruch 2, wobei die Nuten (9) mit einer die zweite Siliziumschicht (12), die Siliziumnitridschicht (13) und die polykristalline Siliziumschicht (14) umfassenden aufeinandergeschichteten Struktur ausgefüllt sind, wobei alle diese Schichten sich in die Nuten (9) erstrecken und in das Siliziumsubstrat (1) eindringen.

4. Vorrichtung nach einem der Ansprüche 1 bis 3, wobei die Schaltungselemente MOSFETs (50 . . . 53) umfassen.

5. Vorrichtung nach einem der Ansprüche 1 bis 3, wobei die Schaltungselemente Bipolar-Vorrichtungen (17 . . . 22) umfassen und das Paar von Nuten (9) durch eine in dem Silizumsubstrat (1) ausgebildete versenkte Kollektorschicht (12) verläuft.

6. Vorrichtung nach einem der Ansprüche 2 bis 6, umfassend

eine auf der polykristallinen Siliziumschicht (14) des Isolierbereichs (24) ausgebildete dritte Siliziumoxidschicht (15) und

eine auf der dritten Siliziumoxidschicht (15) ausgebildete zweite Siliziumnitridschicht (16), die zum Umschließen der polykristallinen Siliziumschicht (14) mit der ersten Siliziumnitridschicht (12) in Berührung steht.

## Revendications

1. Dispositif à circuits intégrés à semiconducteurs comprenant

un substrat en silicium (1),

des zones (2, 3) de dispositif situées sur le substrat (1) et recouvertes par une première couche d'oxyde de silicium (4),

des éléments de circuit (17 . . . 20; 50 . . . 53) formés dans lesdites zones (2, 3) de dispositif,

des zones isolantes (24) séparant l'une de l'autre lesdites zones (2, 3) de dispositif, chaque zone isolante (24) comprenant un couple de gorges (9) espacées l'une de l'autre et s'étendant en direction dudit substrat (1) et une seconde couche d'oxyde de silicium (3) formée sur les surfaces intérieures desdites gorges (9) et entre les gorges (9) appariées, la seconde couche d'oxyde de silicium (12) étant plus épaisse que ladite première couche d'oxyde de silicium (4), et

des câblages (23) disposés sur lesdites zones isolantes (24) et servant à interconnecter lesdits éléments de circuit (17 . . . 19), caractérisé en ce

qu'une couche de nitrure de silicium (13) est prévue en plus de la seconde couche d'oxyde de silicium (12) au moins dans les gorges appariées, et

que la seconde couche d'oxyde de silicium (12) est réalisée par oxydation thermique et possède sensiblement la même épaisseur dans lesdites gorges (9) et entre les gorges appariées (9).

2. Dispositif selon la revendication 1, comprenant une couche de silicium polycristallin (14) formée sur ladite seconde couche d'oxyde de silicium (12) et sur ladite couche de nitrure de silicium (13).

3. Dispositif selon la revendication 2, dans lequel lesdites gorges (9) sont remplies par une structure empilée comprenant ladite seconde couche d'oxyde de silicium (12), ladite couche de nitrure de silicium (13) et ladite couche de silicium polycristallin (14), toutes ces couches s'étendant dans lesdites gorges (9) et pénétrant dans ledit substrat en silicium (1).

4. Dispositif selon l'une quelconque des revendications 1 à 3, dans lequel lesdits éléments de circuit incluent des transistors MOSFET (50 . . . 53).

5. Dispositif selon l'une quelconque des revendications 1 à 3, dans lequel lesdits éléments de circuit incluent des dispositifs bipolaires (17 . . . 22) et ledit couple de gorges (9) s'étend à travers une couche ensevelie de collecteur (2) formée dans ledit substrat en silicium (1).

6. Dispositif selon l'une quelconque des revendications 2 à 6, comprenant

une troisième couche d'oxyde de silicium (15) formée sur ladite couche de silicium polycristallin (14) de ladite zone isolante (24), et

une seconde couche de nitrure de silicium (16) formée sur ladite troisième couche d'oxyde de silicium (15) et placée en contact avec ladite première couche de nitrure de silicium (13) de manière à enfermer ladite couche de silicium polycrystallin (14).

FIG. 1

FIG. 2

FIG. 3

FIG. 4

1

FIG. 5

FIG. 6

FIG. 7

2

FIG. 8

FIG. 9

FIG. 10

FIG. 11

FIG. 12

FIG. 13

FIG. 14

4

FIG. 15

FIG. 16

FIG. 17